# FASCICULE DE BREVET EUROPEEN

(11) **EP 2 149 919 B1**
(45) Date de publication et mention de la délivrance du brevet: **01.04.2015**
(21) Numéro de dépôt: 09165559.7
(22) Date de dépôt: 15.07.2009
(51) Int. Cl.: H01L 33/00, H01L 33/38, H01L 33/32, H01L 33/28

(54) **Diode électroluminescente en matériau semiconducteur et son procédé de fabrication**
Elektrolumineszenzdiode aus Halbleitermaterial und ihr Herstellungsverfahren
Light-emitting diode made from a semiconductor material and manufacturing method thereof

(30) Priorité: 31.07.2008 FR 0855272
(43) Date de publication de la demande: 03.02.2010
(73) Titulaire: Commissariat à l'Énergie Atomique et aux Énergies Alternatives, 75015 Paris (FR)
(72) Inventeur: Robin, Ivan-Christophe, 38000 Grenoble (FR); Ferret, Pierre, 38000 Grenoble (FR); Rothman, Johan, 38250 Lans en Vercors (FR)
(74) Mandataire: Ilgart, Jean-Christophe

(56) Documents cités:
- US-A- 3 492 548
- US-A- 3 714 522
- US-A- 4 800 415
- US-A- 5 247 193
- US-A1- 2004 026 702
- GOODMAN A M: "Field-effect electroluminescence in silicon" RCA REVIEW, RCA CORPORATION, US, vol. 34, no. 3, 1 septembre 1973 (1973-09-01), pages 429-441, XP009125668 ISSN: 0033-6831
- KOIZUMI S ET AL: "Ultraviolet emission from a diamond pn junction" SCIENCE AMERICAN ASSOC. ADV. SCI USA, vol. 292, no. 5523, 8 juin 2001 (2001-06-08), pages 1899-1901, XP002520859 ISSN: 0036-8075
- SADOFEV S ET AL: "Uniform and efficient UV-emitting ZnO/ZnMgO multiple quantum wells grown by radical-source molecular beam epitaxy" JAPANESE JOURNAL OF APPLIED PHYSICS, JAPAN SOCIETY OF APPLIED PHYSICS, TOKYO,JP, vol. 45, no. 46-50, 1 décembre 2006 (2006-12-01), pages L1250-L1252, XP002510404 ISSN: 0021-4922 [extrait le 2006-11-24]
- TSUKAZAKI A ET AL: "Blue light-emitting diode based on ZnO" JAPANESE JOURNAL OF APPLIED PHYSICS, PART 2: LETTERS 2005 JAPAN SOCIETY OF APPLIED PHYSICS JP, vol. 44, no. 20-23, 2005, pages L643-L645, XP002520857
- GOTZ W ET AL: "Activation of acceptors in Mg-doped GaN grown by metalorganic chemical vapor deposition" APPLIED PHYSICS LETTERS AIP USA, vol. 68, no. 5, 29 janvier 1996 (1996-01-29), pages 667-669, XP002520858 ISSN: 0003-6951

## Description

### DOMAINE TECHNIQUE

L'invention se rapporte à une diode électroluminescente en matériau semiconducteur. Elle concerne en particulier les diodes électroluminescentes à base d'oxyde de zinc (ZnO) ou à base de nitrure de gallium (GaN). Elle concerne également son procédé de fabrication.

### ÉTAT DE LA TECHNIQUE ANTÉRIEURE

Une diode électroluminescente ou LED (pour « Light-Emitting Diode » en anglais) est un composant électronique capable d'émettre de la lumière lorsqu'il est parcouru par un courant électrique. On trouve des LED émettant une lumière blanche, une lumière de couleur, une lumière infrarouge ou une lumière située dans l'ultra-violet (UV). Lorsqu'une LED est polarisée en sens direct, la recombinaison des électrons et des trons, dans le matériau semiconducteur de la diode, provoque l'émission de photons.

Le ZnO est un matériau offrant de nombreux avantages pour obtenir une émission dans l'UV à température ambiante. Ceci est dû à son énergie de bande interdite de 3,2 eV à température ambiante et à son énergie de liaison de 60 meV, bien supérieure à l'énergie thermique de 2,5 meV à température ambiante. Cependant, le facteur limitant actuellement la réalisation de LED à partir de ZnO est l'obtention de ZnO dopé p, nécessaire pour obtenir une diode.

Les matériaux à base de GaN (GaN, GaInN, GaAlN) ou nitrures sont les matériaux actuellement utilisés commercialement pour réaliser des LED dans le bleu et l'UV. Effectivement, l'énergie de bande interdite du GaN, de 3,42 eV à température ambiante, permet d'obtenir une émission UV. Cependant, on trouve principalement des diodes réalisées à partir d'alliages GaInN émettant dans le bleu. Par rapport du ZnO, l'énergie de liaison de l'exciton est plus faible, de l'ordre de 30 meV, ce qui est une limitation intrinsèque du matériau pour obtenir un bon rendement d'électroluminescence à température ambiante.

La technique utilisée actuellement pour fabriquer des LED à base de matériau semiconducteur consiste à réaliser une jonction p/n, ce qui revient à mettre en contact un matériau de type p avec un matériau de type n. Une zone de déplétion est alors obtenue au niveau de la jonction. On peut alors faire passer un courant dans la structure obtenue et provoquer des recombinaisons radiatives des charges au niveau de la zone de déplétion. C'est la technique qui est utilisée actuellement pour réaliser par exemple des diodes électroluminescentes à base de GaN. Le GaN est naturellement de type n mais il est possible de le doper p en utilisant un dopage en magnésium. On peut se référer à ce sujet aux articles suivants :
- T. TANAKA et al., Appl. Phys. Lett. 65, 593 (1994) et
- W. GOTZ et al., Appl. Phys. Lett. 68, 667 (1996).

Du GaN et du GaAlN de type p avec des concentrations en accepteurs de l'ordre de 8.10²⁰/cm³ et des mobilités de l'ordre de 15 cm²/V.s peuvent être obtenues (voir l'article de J.D. THOMSON et al., J. Appl. Phys. 99, 024507 (2006)).

Des jonctions p/n peuvent être réalisées pour fabriquer des LED à base et GaN émettant dans l'UV. On peut se référer à ce sujet à l'article de J.D. THOMSON cité ci-dessus et à S. NAKAMURA et al., Appl. Phys. Lett. 67, 1868 (1995).

Le ZnO est lui aussi naturellement de type n et ceci quelle que soit la technique de croissance utilisée. Des travaux ont été mené pour réaliser du ZnO de type p, mais la concentration d'accepteurs et la mobilisation des trous sont très faibles. Actuellement, il n'a toujours pas été possible d'obtenir une électroluminescence intense dans le bleu ou dans l'UV à partir de ZnO.

Le document US 3714522 décrit une diode électroluminescente avec les charactéristiques mentionnées dans le préambule de la revendication 1.

### EXPOSÉ DE L'INVENTION

La présente invention a été conçue pour permettre de contourner le problème du dopage p du ZnO en inversant le type de dopage dans une zone d'une structure ZnO par l'utilisation d'une grille. Cette technique est applicable à tout matériau semiconducteur pour provoquer l'émission de lumière, en particulier à des matériaux tels que ZnO, GaN, GaAs. Elle permet la réalisation de matrices LED de tailles micrométriques facilement adressables pour faire par exemple de l'affichage, chaque LED de la matrice constituant un élément d'image ou pixel.

Un premier objet de l'invention est constitué par une diode électroluminescente comprenant une structure en matériau semiconducteur d'un premier type de conductivité et des moyens de polarisation électrique de la diode, dans laquelle :
- la structure présente une première face dont une première zone est en contact avec un plot de matériau semiconducteur d'un deuxième type de conductivité opposé au premier type de conductivité ,
- les moyens de polarisation comprennent :
   - un contact électrique sur le plot,
   - un contact électrique sur la première face ou sur une deuxième face de la structure,
   - une grille en matériau électriquement conducteur disposée sur une deuxième zone de la première face et séparée de la première face par une couche électriquement isolante, caractérisée en ce que le matériau semiconducteur d'un deuxième type de conductivité est de nature différente du matériau semiconducteur d'un premier type de conductivité.

Selon un mode particulier de réalisation, la grille est un disque possédant un trou central qui entoure ledit plot.

Le plot de matériau semiconducteur peut être logé dans une cavité formée à partir de la première face de la structure.

Le matériau semiconducteur d'un premier type de conductivité peut être choisi parmi ZnO, GaN et GaAs. Dans ce cas, le matériau semiconducteur du plot peut être choisi parmi ZnO, GaN, GaInN, GaAs et GaInAs.

Le matériau semiconducteur d'un premier type de conductivité peut être du diamant. Dans ce cas, le matériau semiconducteur du plot peut être choisi parmi MgO, ZnO et ZnMgO.

La grille peut être en un matériau choisi parmi les métaux et alliages de métaux. De préférence, le métal est choisi parmi l'or, le cuivre et le platine.

La couche électriquement isolante peut être en SiO₂.

Les contacts électriques peuvent être en un matériau choisi parmi l'or, le cuivre et le platine.

Selon un autre mode de réalisation, la structure en matériau semiconducteur est une structure à puits quantique. La structure en matériau semiconducteur peut être en ZnMgO avec un puits quantique en ZnO. Les moyens de polarisation peuvent être tels qu'ils permettent de placer le puits quantique au niveau de la jonction p/n de la diode lorsque la diode est polarisée.

Un deuxième objet de l'invention consiste en un procédé de réalisation d'une diode électroluminescente à partir d'une structure en matériau semiconducteur d'un premier type de conductivité, comprenant :
- la formation, dans une première zone d'une première face de la structure, d'un plot de matériau semiconducteur d'un deuxième type de conductivité opposé au premier type de conductivité, le matériau semiconducteur d'un deuxième type de conductivité étant de nature différente du matériau semiconducteur d'un premier type de conductivité,
- la formation de moyens de polarisation de la diode, comprenant :
   - la formation d'un contact électrique sur le plot,
   - la formation d'un contact électrique sur la première face ou sur une deuxième face de la structure,
   - la formation d'une grille en matériau électriquement conducteur disposée sur une deuxième zone de la première face et séparée de la première face par une couche électriquement isolante.

L'invention s'applique à toute structure semiconductrice pour produire de l'émission de lumière (ZnO, GaN, GaAs, etc...). Elle permet de réaliser des matrices de LED de tailles micrométriques facilement adressables pour faire de l'affichage par exemple, chaque LED de la matrice étant un élément d'image ou pixel.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A et 1B sont des vues respectivement en coupe transversale et de dessus d'une diode électroluminescente selon l'invention,
- la figure 2 illustre le fonctionnement d'une première diode électroluminescente selon l'invention,
- la figure 3 illustre le fonctionnement d'une deuxième diode électroluminescente selon l'invention,
- la figure 4 illustre le fonctionnement d'une troisième diode électroluminescente selon l'invention.

### EXPOSÉ DÉTAILLÉ DE MODES DE RÉALISATION PARTICULIERS

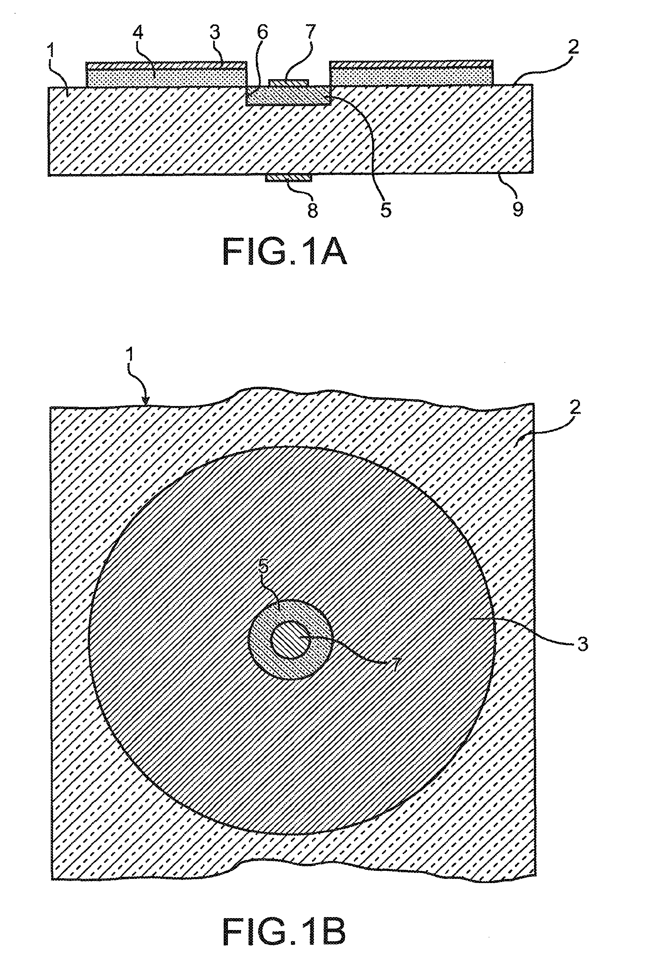

Les figures 1A et 1B sont des vues respectivement en coupe transversale et de dessus d'une diode électroluminescente selon l'invention.

La diode comprend une structure 1 en matériau semiconducteur d'un premier type de conductivité. Sur une première face 2 de la structure 1, on a formé une grille 3 en matériau électriquement conducteur, la grille 3 étant séparée de la face 2 par une couche 4 de matériau électriquement isolant. Dans cet exemple de réalisation, la grille 3 et la couche 4 sont en forme de disque avec un trou central commun. Le trou central commun laisse apparaître un plot 5 de matériau semiconducteur d'un deuxième type de conductivité opposé au premier type de conductivité. A titre d'exemple ne faisant pas partie de l'invention, le matériau de la structure 1 est du ZnO de type n et le matériau du plot 5 est du ZnO dopé de type p par implantation ionique.

Le plot 5 est logé dans une cavité 6 de la structure 1, formée à partir de la première face 2.

Des connexions électriques sont formées sur la diode obtenue. Elles comprennent une connexion avec la grille 3, un contact 7 disposé sur le plot 5 et un contact 8 disposé sur une deuxième face 9 de la structure, opposée à la première face 2. En variante, le contact 8 peut être disposé sur la première face 2 de la structure.

A titre d'exemple, la structure 1 peut avoir 100 nm à 50 µm d'épaisseur, la couche électriquement isolante 4 peut avoir 30 nm à 70 nm d'épaisseur. Dans le cas où la grille 3 est un disque percé en son centre, le diamètre du disque peut varier entre une fraction de µm et quelques mm. Le diamètre du trou central du disque et le diamètre de la cavité 6 peuvent varier entre quelques centaines de nanomètres et 1 µm.

Le matériau semiconducteur de la structure 1 peut être de type n auquel cas le matériau semiconducteur du plot 5 est de type p. Inversement, si le matériau semiconducteur de la structure 1 est de type p, le matériau semiconducteur du plot est de type n.

Par exemple, des structures 1 en ZnO de type n sont réalisées à partir d'une plaquette de ZnO. Une couche de matériau électriquement isolant est formée sur la face 2 de la structure 1. Il s'agit par exemple d'une couche de SiO₂ déposée par pulvérisation cathodique. Une couche de matériau électriquement conducteur, par exemple une couche d'or déposée par pulvérisation cathodique est formée sur la couche de matériau électriquement isolant. La couche isolante et la couche conductrice sont alors lithographiées et gravées par gravure ionique réactive ou RIE (pour « Reactive Ion Etching ») pour leur donner la forme de disque percée en leur centre. La lithographie peut utiliser des sphères nanométriques de 100 à 200 nm de diamètre.

La cavité 6 est alors gravée par gravure ionique réactive, la couche conductrice et la couche isolante formant un masque de gravure. On dépose ensuite dans la cavité 6 le plot 5 de matériau semiconducteur de type p par croissance organométallique, électrolyse ou épitaxie par jets moléculaires, dans le cas où le matériau du plot 5 est de nature différente du matériau de la structure 1. A titre d'exemple en dehors de la présente invention, on peut aussi former dans la cavité 6 le plot 5 de matériau semiconducteur de type p par implantation ionique ou diffusion de dopants dans le matériau de la structure 1.

On forme ensuite le contact 7 sur le plot 5 et le contact 8 sur la face 9 par dépôt et « lift-off » ou par dépôt et gravure.

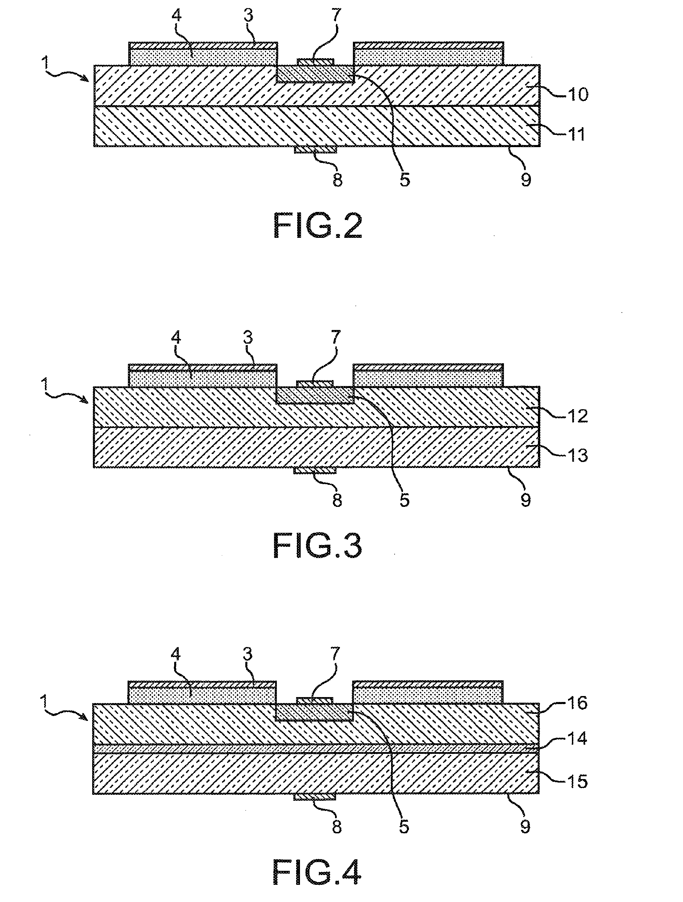

Le matériau semiconducteur de type p du plot 5 possède une énergie de bande interdite voisine de celle du ZnO. Son niveau de dopage ne doit pas forcément être très élevé et la mobilité des trous ne doit pas non plus forcément être très élevée. Ce matériau de type p permet uniquement de prendre un contact de type p et d'injecter des trous dans la zone d'inversion qui sera créée en appliquant une tension négative comme représentée sur la figure 2.

La figure 2 illustre le fonctionnement d'une diode ainsi réalisée. En appliquant une tension négative à la grille, d'environ -10 V par rapport au potentiel de la structure 1 imposé par l'électrode 8, on réalise un « pseudo-jonction p/n ». En faisant passer un courant dans la structure grâce au contact p (le contact 7) et au contact n (le contact 8), on peut injecter des trous dans la région 10 de type p et des électrons dans la région 11 de type n et obtenir de l'électroluminescence. L'allumage de la diode peut être contrôlé grâce à la tension appliquée à la grille. L'invention s'applique à tout type de matériau semiconducteur, que ce soit un matériau intrinsèquement dopé n ou pouvant facilement être dopé n mais difficile à doper p (ZnO, GaN, ...) ou un matériau pouvant facilement être dopé p mais difficile à doper n (comme le diamant par exemple).

Dans le cas d'un matériau facile à doper p mais difficile à doper n, comme le diamant, il faut, dans l'ouverture de la grille, déposer du matériau semiconducteur de type n, même s'il est faiblement dopé avec des mobilités d'électrons faibles, et appliquer une tension positive à la grille, d'environ 10 V par rapport au potentiel de la structure 1 imposé par l'électrode 8, pour inverser une région naturellement de type p en une région de type n. La figure 3 illustre le fonctionnement d'une diode ainsi réalisée. En faisant passer un courant dans la structure 1 initialement de type p (comme le diamant) grâce au contact n (le contact 7) et au contact p (le contact 8), on peut injecter des électrons dans la région 12 de type n et des trous dans la région 13 de type p et obtenir l'électroluminescence. L'allumage de la diode peut être contrôlé grâce à la tension appliquée à la grille.

Les résultats suivants ont été obtenus pour une structure en GaN naturellement de type n à 10¹⁸/cm³ avec un plot en GaN de type p à 10¹⁶/cm³ et une ouverture de grille de 200 nm de diamètre. L'application d'une tension de -5 V à la grille permet l'obtention d'une région de type p sous la grille qui peut être étendue jusqu'à 100 nm sous la grille. Dans cette région, référencée 10 sur la figure 2, pour un courant de 1 à 10 mA, une bonne efficacité de combinaison radiative est alors obtenue.

De bons résultats peuvent aussi être obtenus par utilisation d'une hétérojonction avec un matériau de type p dans l'ouverture de grille, de nature différente que celui utilisé pour la structure. Ces résultats ont été obtenus pour une structure en GaN de type n à 10¹⁸/cm³ avec un plot en GaInN de type p à 10¹⁶/cm³ et une ouverture de grille de 200 nm de diamètre. Le pourcentage d'indium dans le GaInN est tel que l'énergie de bande interdite est de 3,4 eV. Pour un courant de 1 à 10 mA, une bonne efficacité de recombinaison radiative est obtenue au voisinage de la grille.

Pour augmenter l'efficacité de recombinaison, des structures à puits quantique peuvent être utilisées. La profondeur de la région d'inversion peut être contrôlée par la tension de grille qui peut être ajustée de telle manière que le puits quantique se trouve au niveau de la jonction p/n par exemple.

La figure 4 illustre le fonctionnement d'une telle diode électroluminescente. La structure 1 comprend une région 14 en ZnO prise en sandwich entre des régions 15 et 16 en ZnMgO. L'application d'une tension négative à la grille 3 permet l'inversion de la région 16 en ZnMgO naturellement de type n en une région de type p et permet de placer le puits quantique 14 au niveau de la jonction p/n.

La présente invention permet de réaliser des diodes électroluminescentes ou LED même à partir de matériaux semiconducteurs pour lesquels un type de dopage (n ou p) est difficile.

Cette invention permet aussi de réaliser des matrices de LED dont l'allumage est contrôlé uniquement par l'application d'une tension de grille.

## Revendications

1. Diode électroluminescente comprenant une structure (1) en matériau semiconducteur d'un premier type de conductivité et des moyens de polarisation électrique de la diode, dans laquelle :
- la structure (1) présente une première face (2) dont une première zone est en contact avec un plot (5) de matériau semiconducteur d'un deuxième type de conductivité opposé au premier type de conductivité ,
- les moyens de polarisation comprennent :
• un contact électrique (7) sur le plot (5),
• un contact électrique (8) sur la première face (2) ou sur une deuxième face (9) de la structure (1),
• une grille (3) en matériau électriquement conducteur disposée sur une deuxième zone de la première face et séparée de la première face par une couche électriquement isolante (4),
**caractérisée en ce que** le matériau semiconducteur d'un deuxième type de conductivité est de nature différente du matériau semiconducteur d'un premier type de conductivité.

2. Diode électroluminescente selon la revendication 1, dans laquelle la grille (3) est un disque possédant un trou central qui entoure ledit plot (5).

3. Diode électroluminescente selon l'une des revendications 1 ou 2, dans laquelle, le plot (5) de matériau semiconducteur est logé dans une cavité (6) formée à partir de la première face (2) de la structure (1).

4. Diode électroluminescente selon l'une quelconque des revendications 1 à 3, dans laquelle le matériau semiconducteur d'un premier type de conductivité est choisi parmi ZnO, GaN et GaAs.

5. Diode électroluminescente selon la revendication 4, dans laquelle le matériau semiconducteur dudit plot (5) est choisi parmi ZnO, GaN, GaInN, GaAs et GaInAs.

6. Diode électroluminescente selon l'une quelconque des revendications 1 à 3, dans laquelle le matériau semiconducteur d'un premier type de conductivité est du diamant.

7. Diode électroluminescente selon la revendication 6, dans laquelle le matériau semiconducteur dudit plot (5) est choisi parmi MgO, ZnO et ZnMgO.

8. Diode électroluminescente selon l'une quelconque des revendications 1 à 7, dans laquelle la grille (3) est en un matériau choisi parmi l'or, le cuivre et le platine.

9. Diode électroluminescente selon l'une quelconque des revendications 1 à 8, dans laquelle la couche électriquement isolante (4) est en SiO₂.

10. Diode électroluminescente selon l'une quelconque des revendications 1 à 9, dans laquelle les contacts électriques (7, 8) sont en un matériau choisi parmi l'or, le cuivre et le platine.

11. Diode électroluminescente selon l'une quelconque des revendications 1 à 3, dans laquelle la structure en matériau semiconducteur est une structure à puits quantique.

12. Diode électroluminescente selon la revendication 11, dans laquelle la structure en matériau semiconducteur est en ZnMgO avec un puits quantique (14) en ZnO.

13. Diode électroluminescente selon l'une quelconque des revendications 11 ou 12, dans laquelle les moyens de polarisation permettent de placer le puits quantique (14) au niveau de la jonction p/n de la diode lorsque la diode est polarisée.

14. Procédé de réalisation d'une diode électroluminescente à partir d'une structure (1) en matériau semiconducteur d'un premier type de conductivité, comprenant :
- la formation, dans une première zone d'une première face (2) de la structure (1), d'un plot (5) de matériau semiconducteur d'un deuxième type de conductivité opposé au premier type de conductivité, le matériau semiconducteur d'un deuxième type de conductivité étant de nature différente du matériau semiconducteur d'un premier type de conductivité,
- la formation de moyens de polarisation de la diode, comprenant :
• la formation d'un contact électrique (7) sur le plot (5),
• la formation d'un contact électrique (8) sur la première face (2) ou sur une deuxième face (9) de la structure (1),
• la formation d'une grille (3) en matériau électriquement conducteur disposée sur une deuxième zone de la première face et séparée de la première face par une couche électriquement isolante (4).

## Patentansprüche

1. Elektrolumineszenz-Diode, umfassend eine Struktur (1) aus Halbleitermaterial eines ersten Leitfähigkeitstyps sowie Mittel zur elektrischen Polarisation der Diode, bei der:
- die Struktur (1) eine erste Seite (2) aufweist, von der eine erste Zone in Kontakt mit einem Kontaktstück (5) aus Halbleitermaterial eines zweiten Leitfähigkeitstyps ist, der dem ersten Leitfähigkeitstyp entgegengesetzt ist,
- wobei die Polarisationsmittel umfassen:
• einen elektrischen Kontakt (7) an dem Kontaktstück (5),
• einen elektrischen Kontakt (8) an der ersten Seite (2) oder an einer zweiten Seite (9) der Struktur (1),
• ein Gitter (3) aus elektrisch leitendem Material, welches an einer zweiten Zone der ersten Seite angeordnet und von der ersten Seite durch eine elektrisch isolierende Schicht (4) getrennt ist,
• **dadurch gekennzeichnet, dass** das Halbleitermaterial eines zweiten Leitfähigkeitstyps von anderer Art als das Halbleitermaterial eines ersten Leitfähigkeitstyps ist.

2. Elektrolumineszenz-Diode nach Anspruch 1, bei der das Gitter (3) eine Scheibe ist, die ein zentrales Loch besitzt, welches das Kontaktstück (5) umgibt.

3. Elektrolumineszenz-Diode nach einem der Ansprüche 1 oder 2, bei der das Kontaktstück (5) aus Halbleitermaterial in einem Hohlraum (6) untergebracht ist, der ausgehend von der ersten Seite (2) der Struktur (1) gebildet ist.

4. Elektrolumineszenz-Diode nach einem der Ansprüche 1 bis 3, bei der das Halbleitermaterial eines ersten Leitfähigkeitstyps ausgewählt ist aus ZnO, GaN und GaAs.

5. Elektrolumineszenz-Diode nach Anspruch 4, bei der das Halbleitermaterial des Kontaktstücks (5) ausgewählt ist aus ZnO, GaN, GalnN, GaAs und GalnAs.

6. Elektrolumineszenz-Diode nach einem der Ansprüche 1 bis 3, bei der das Halbleitermaterial eines ersten Leitfähigkeitstyps Diamant ist.

7. Elektrolumineszenz-Diode nach Anspruch 6, bei der das Halbleitermaterial des Kontaktstücks (5) ausgewählt ist aus MgO, ZnO und ZnMgO.

8. Elektrolumineszenz-Diode nach einem der Ansprüche 1 bis 7, bei der das Gitter (3) aus einem Material hergestellt ist, ausgewählt aus Gold, Kupfer und Platin.

9. Elektrolumineszenz-Diode nach einem der Ansprüche 1 bis 8, bei der die elektrisch isolierende Schicht (4) aus SiO₂ ist.

10. Elektrolumineszenz-Diode nach einem der Ansprüche 1 bis 9, bei der die elektrischen Kontakte (7, 8) aus einem Material ausgewählt aus Gold, Kupfer und Platin hergestellt sind.

11. Elektrolumineszenz-Diode nach einem der Ansprüche 1 bis 3, bei der die Struktur aus Halbleitermaterial eine Quantentopfstruktur ist.

12. Elektrolumineszenz-Diode nach Anspruch 11, bei der die Struktur aus Halbleitermaterial aus ZnMgO ist, mit einem Quantentopf (14) aus ZnO.

13. Elektrolumineszenz-Diode nach einem der Ansprüche 11 oder 12, bei der die Polarisationsmittel es ermöglichen, den Quantentopf (14) im Bereich des p/n-Übergangs der Diode zu platzieren, wenn die Diode polarisiert ist.

14. Verfahren zur Herstellung einer Elektrolumineszenz-Diode ausgehend von einer Struktur (1) aus Halbleitermaterial eines ersten Leitfähigkeitstyps, umfassend:
- die Herstellung, in einer ersten Zone einer ersten Seite (2) der Struktur (1), eines Kontaktstücks (5) aus Halbleitermaterial eines zweiten Leitfähigkeitstyps, welcher dem ersten Leitfähigkeitstyp entgegengesetzt ist, wobei das Halbleitermaterial eines zweiten Leitfähigkeitstyps von anderer Art als das Halbleitermaterial eines ersten Leitfähigkeitstyps ist,
- die Bildung von Mitteln zur Polarisation der Diode, umfassend:
• die Bildung eines elektrischen Kontakts (7) an dem Kontaktstück (5),
• die Bildung eines elektrischen Kontakts (8) an der ersten Seite (2) oder an einer zweiten Seite (9) der Struktur (1),
• die Bildung eines Gitters (3) aus elektrisch leitendem Material, das an einer zweiten Zone der ersten Seite angeordnet und von der ersten Seite durch eine elektrisch isolierende Schicht (4) getrennt ist.

## Claims

1. Light-emitting diode comprising a structure (1) in a semiconductor material of first conductivity type and means for electric polarisation of the diode, wherein:
- the structure (1) has a first face (2) of which a first region is in contact with a pad (5) of semiconductor material having a second conductivity type opposite the first conductivity type,
- the polarisation means comprise:
• an electric contact (7) on the pad (5),
• an electric contact (8) on the first face (2) or on a second face (9) of the structure (1),
• a gate (3) in electrically conductive material arranged on a second region of the first face and separated from the first face by an electrically insulating layer (4), **characterized in that** the first semiconductor material of a second type of conductivity is from a different kind than the semiconductor material of a first type of conductivity.

2. Light-emitting diode according to claim 1, wherein the gate (3) is a disc having a central hole surrounding said pad (5).

3. Light-emitting diode according to either of claims 1 or 2, wherein the pad (5) of semiconductor material is housed in a cavity (6) formed from the first face (2) of the structure (1).

4. Light-emitting diode according to any of claims 1 to 3, wherein the semiconductor material of first conductivity type is chosen from among ZnO, GaN and GaAs.

5. Light-emitting diode according to claim 4, wherein the semiconductor material of said pad (5) is chosen from among ZnO, GaN, GaInN, GaAs and GaInAs.

6. Light-emitting diode according to any of claims 1 to 3, wherein the semiconductor material of first conductivity type is diamond.

7. Light-emitting diode according to claim 6, wherein the semiconductor material of said pad (5) is chosen from among MgO, ZnO and ZnMgO.

8. Light-emitting diode according to any of claims 1 to 7, wherein the gate (3) is in a material chosen from among gold, copper and platinum.

9. Light-emitting diode according to any of claims 1 to 8, wherein the electrically insulating layer (4) is in SiO₂.

10. Light-emitting diode according to any of claims 1 to 9, wherein the electric contacts (7, 8) are in a material chosen from among gold, copper and platinum.

11. Light-emitting diode according to any of claims 1 to 3, wherein the structure in semiconductor material is a quantum well structure.

12. Light-emitting diode according to claim 11, wherein the structure in semiconductor material is in ZnMgO with a quantum well (14) in ZnO.

13. Light-emitting diode according to either of claims 11 or 12, wherein the polarising means allow the quantum well (14) to be positioned at the p/n junction of the diode when the diode is polarised.

14. Method to fabricate a light-emitting diode from a structure (1) in semiconductor material of first conductivity type, comprising:
- forming, in a first region of a first face (2) of the structure (1), a pad (5) of semiconductor material having a second type of conductivity opposite the first type of conductivity, the first semiconductor material of a second type of conductivity is from a different kind than the semiconductor material of a first type of conductivity,
- forming means to polarise the diode, comprising:
• forming an electric contact (7) on the pad (5),
• forming an electric contact (8) on the first face (2) or on a second face (9) of the structure (1),
• forming a gate (3) in electrically conductive material arranged on a second region of the first face and separated from the first face by an electrically insulating layer (4).
